**Europäisches Patentamt**

(19) **European Patent Office**

**Office européen des brevets**

(11) Veröffentlichungsnummer: **0 124 938**
**B1**

(12) **EUROPÄISCHE PATENTSCHRIFT**

(45) Veröffentlichungstag der Patentschrift:
16.12.87

(51) Int. Cl.⁴: **C 30 B 15/10, C 30 B 29/28**

(21) Anmeldenummer: **84200625.6**

(22) Anmeldetag: **03.05.84**

(54) **Kalter Tiegel für das Erschmelzen nichtmetallischer anorganischer Verbindungen.**

(30) Priorität: **06.05.83 DE 3316547**

(43) Veröffentlichungstag der Anmeldung:
**14.11.84 Patentblatt 84/46**

(45) Bekanntmachung des Hinweises auf die Patenterteilung:
**16.12.87 Patentblatt 87/51**

(84) Benannte Vertragsstaaten:
**AT CH DE FR GB LI**

(56) Entgegenhaltungen:
DE-A-1 948 194
DE-C-976 672
FR-A-2 099 638
US-A-3 824 302

**JOURNAL OF CRYSTAL GROWTH, Band 65, Nr. 1/3, Dezember 1983, Seiten 237-242, Elsevier Science Publishers B.V., Amsterdam, NL; D. MATEIKA et al.: "Czochralski growth by the double container technique"**

(73) Patentinhaber: **Philips Patentverwaltung GmbH, Wendenstrasse 35 Postfach 10 51 49, D-2000 Hamburg 1 (DE)**
(84) Benannte Vertragsstaaten: **DE**

(73) Patentinhaber: **N.V. Philips' Gloeilampenfabrieken, Groenewoudseweg 1, NL- 5621 BA Eindhoven (NL)**
(84) Benannte Vertragsstaaten: **CH FR GB LI AT**

(72) Erfinder: **Mateika, Dieter, Dr., Seerosenstrasse 16, D-2087 Ellerbek (DE)**
Erfinder: **Laurien, Rolf, Am Wall 53, D-2080 Pinneberg (DE)**

(74) Vertreter: **Nehmzow- David, Fritzi- Maria, Philips Patentverwaltung GmbH Wendenstrasse 35 Postfach 10 51 49, D-2000 Hamburg 1 (DE)**

EP 0 124 938 B1

## Beschreibung

Die Erfindung betrifft einen kalten Tiegel für das Erschmelzen und die Kristallisation nichtmetallischer anorganischer Verbindungen mit einer gekühlten Tiegelwandung in Form von von Kühlmedium durchströmten Metallrohren, die in mechanischer Verbindung stehen mit dem ebenfalls von Kühlmedium durchspülten Tiegelboden und mit einer ersten Induktionsspule, die die Tiegelwandung umgibt und über die Hochfrequenz-Energie in den Tiegelinhalt einkoppelbar ist, sowie mit einer zweiten, unabhängig von der die Tiegelwandung umgebenden Induktionsspule zu schaltenden Induktionsspule, die unterhalb des Tiegelbodens angeordnet ist.

Die Erfindung bezieht sich weiter auf die Verwendung des kalten Tiegels zum Züchten von Einkristallen auh Schmelzen auf der Basis von Seltenerdmetall/Gallium-Granat.

Ein kalter Tiegel ist geeignet für die Durchführung des sogenannten skull-melting-Verfahrens zum Erschmelzen von Ausgangsmaterialien für die Züchtung von Einkristallen durch direkte Einkopplung eines elektromagnetischen Feldes von einer Induktions-Spule in das zu erwärmende Material. Als Tiegel werden wassergekühlte Kupferrohre benutzt, die kreisförmig dicht an dicht nebeneinander angeordnet sind. Der Tiegelboden kann aus einer wassergekühlten Metallplatte oder aus mehreren Kupferrohren bestehen, wobei um die zylinderförmige Tiegelwandung herum eine Hochfrequenz-Spule angeordnet ist. Das elektromagnetische Feld dringt durch die Spalte zwischen den Kupferrohren hindurch in das Innere des Tiegels ein. Ein derartiger Tiegel ist zum Beispiel bekannt aus V.I. Aleksandrov, V.V. Osiko, A.M. Prokhorov und V.M. Tatarintsev "Synthesis and Crystal Growth of Refractory Materials by RF Melting in a Cold Container" in: Current Topics in Materials Science, Vol. 1, ed. by B. Kaldis, North Holland Publ. Comp., 1978.

Anhand eines Beispieles soll die Arbeitsweise eines derartigen bekannten kalten Tiegels erläutert werden. Zum Schmelzen wird im allgemeinen das Material in Pulverform in den Tiegel gefüllt. Schlechtleitende Oxide müssen zunächst vorgeheizt werden. Hierfür werden Metallstücke aus Metall, das dem zu erschmelzenden Oxid entspricht verwendet, die in das Pulver eingebettet werden (siehe z. B. US-A-3 824 302). Das elektromagnetische Feld heizt aufgrund der induzierten Wirbelströme zunächst die Metallstücke auf, die ihrerseits das Oxidpulver in der näheren Umgebung schmelzen. In die sich bildende Schmelze kann das Feld der Hochfrequenz-Spule wegen der höheren elektrischen Leitfähigkeit der Schmelze direkt einkoppeln. Durch Erhöhung der Hochfrequenz-Leistung wird kontinuierlich weiteres Oxidpulver geschmolzen, bis die Schmelze in die Nähe der Tiegelwandung kommt. Die wassergekühlte innere Tiegelfläche sorgt dafür, daß sich zwischen ihr und der heißen Schmelze eine dichtgesinterte, arteigene, in fester Phase vorliegende Schicht bildet, die den Tiegel vor dem Angriff durch die Schmelze schützt. Das zum Vorheizen benutzte Metall wird durch Sauerstoff der Luft in das zu erschmelzende Oxid umgewandelt.

Mit derartigen bekannten Tiegeln sind z. B. $Al_2O_3$-Ein-kristalle gezüchtet worden. Zu diesem Zweck ist eine $Al_2O_3$-Schmelze mit einem Impfkristall aus Saphir angeimpft worden. Durch Wegziehen des Impfkristalls von der Schmelzenoberfläche mit einer Geschwindigkeit von 10 bis 30 mm/h konnten $Al_2O_3$-Einkristalle mit einer Länge bis zu 160 mm und einem Durchmesser bis zu 35 mm hergestellt werden.

Es hat sich nun gezeigt, daß mit dem bekannten Tiegel nur in den wenigsten Fällen einwandfreie Kristalle gezüchtet werden können. Insbesondere bei Schmelzen niedriger Viskosität können sich Schwierigkeiten ergeben. Auf der Oberfläche der Schmelzen werden z. B. turbulente Flußlinien beobachtet, die darauf hinweisen, daß als Folgeerscheinung der Absorption des Hochfrequenz-Feldes in der Schmelze turbulente Konvektionsströme induziert werden. Eine radiale Temperaturvertellung auf der Oberfläche der Schmelze mit einem Temperaturminimum im Zentrum, wie sie für die Züchtung von Einkristallen benötigt wird, kann sich in einer solchen Schmelze nicht einstellen. Bei Erniedrigung der Schmelzentemperatur zum Zwecke der Vergrößerung des Kristalldurchmessers des zu züchtenden Kristalls wachsen gleichzeitig auch die Kristallkeime auf der in fester Phase auf der gekühlten Tiegelinnenwandung und dem gekühlten Tiegelinnenboden vorliegenden Sinterschicht. Durch die Zunahme der Dicke dieser Schicht verringert sich das Volumen der Schmelze und damit ihr elektrischer Leitwert. Die elektrische Leistung koppelt nicht mehr genügend ein, so daß die Schmelzentemperatur weiter absinkt. Dieser Vorgang verläuft exponentiell beschleunigt, so daß auch bei Erhöhung der Hochfrequenz-Leistung nach kurzer Zeit die Schmelze ein kritisches Volumen erreicht und erstarrt.

Die Wärmeverluste an den gekühlten Flächen der Innenwandung des Tiegels und die Notwendigkeit, möglichst weit oberhalb des kritischen Schmelzenvolumens (dünne Sinterschicht) zu arbeiten, machen eine erhebliche Überhitzung der Schmelze erforderlich. Folgeerscheinungen dieser Überhitzung sind die Verdampfung flüchtiger Materialkomponenten und turbulente Schmelzenkonvektionen, gekoppelt mit Temperaturfluktuationen.

Der Erfindung liegt die Aufgabe zugrunde, einen kalten Tiegel bereitzustellen, bei dem die beschriebenen Schwierigkeiten nicht auftreten, mit dem sich Turbulenzen in der Schmelze einwandfrei beherrschen lassen und bei dem der Temperaturgradient in der Schmelze so einstellbar ist, daß sich einwandfrei auch große Einkristalle züchten lassen.

Diese Aufgabe wird erfindungsgemäß dadurch gelöst, daß innerhalb des Tiegels mit einem Abstand über dem Tiegelboden ein Körper aus einem inerten, elektrisch leitfähigen Material und ein zur offenen Seite des Tiegels hin offener, mit Öffnungen versehener, aus einem inerten Material bestehender Behälter, der einen solchen Abstand von der Tiegelwandung und vom Tiegelboden hat, daß in ihm bis zu 25 % des gesamten Tiegelinhaltes enthalten sind, vorgesehen sind.

Nach einer weiteren vorteilhaften Ausgestaltung der Erfindung besteht der Tiegelboden aus dielektrischem Material. Hiermit ist der Vorteil verbunden, daß bei Induktiver Beheizung des Tiegelinhaltes vom Tiegelboden her keine elektrischen Verluste auftreten.

Nach einer weiteren vorteilhaften Ausgestaltung der Erfindung besteht der Tiegelboden aus einer Quarzplatte, unter der das Kühlmedium fließt und die in eine Halterung aufgenommen ist, die mit federnd gelagerten Stützen verbunden ist. Hiermit ist der Vorteil verbunden, daß in vertikaler Richtung auftretende Kräfte infolge einer Ausdehnung der Schmelze beim Aufheizen kompensiert werden, so daß eine Zerstörung der Quarzplatte verhindert wird. Auf diese Weise verlängert sich die Standzeit des Tiegels erheblich.

Nach vorteilhaften Weiterbildungen der Erfindung bestehen der Körper und der Behälter aus Iridium, Platin oder Graphit. Diese Materialien sind inert gegenüber Schmelzen aus nichtmetallischen, anorganischen Verbindungen und werden je nach Zweckmäßigkeit ausgewählt. Da der Körper in jedem Fall als Heizkörper für die Aufheizung der Schmelze wirken soll, ist es erforderlich, daß er aus elektrisch leitfähigem Material besteht, das infolge induzierter Wirbelströme schnell aufheizbar ist. Der Behälter kann dagegen einmal als Zusatzheizung wirken, dann ist für ihn ebenfalls elektrisch leitfähiges, gegenüber der Schmelze inertes Material auszuwählen, er kann hingegen auch allein die Funktion wahrnehmen, innerhalb der Schmelze einen von Turbulenzen beruhigten Schmelzenbereich zu schaffen, er könnte dann aus einem gegenüber der Schmelze inerten Material bestehen, das sich nicht leicht induktiv zu erhitzen braucht.

Mit dem Tiegel gemäß der Erfindung sind allgemein die Vorteile verbunden, daß infolge der getrennt zu schaltenden Induktionsspulen durch unterschiedliche Energieeinspeisung eine örtlich gezielte Erhitzung des Tiegelinhaltes vorgenommen werden kann, daß also der Temperaturgradient in der Schmelze beeinflußbar wird. Mit dem Behälter kann eine radiale Temperaturverteilung in der Schmelze mit einem Temperaturminimum im Zentrum der Schmelzenoberfläche erreicht werden. Ein weiterer Vorteil des erfindungsgemäßen Tiegels ist, daß mittels der Öffnungen im Behälter die Schmelzenkonvektion im Innenraum des Tiegels gezielt beeinflußbar ist. Hierdurch und durch die geringe Schmelzenhöhe im Innenraum des Behälters werden instabile Wachstumsperioden vermieden, was sich als ganz besonders vorteilhaft erwiesen hat bei Schmelzen, die eine niedrige Viskosität haben, z. B. Schmelzen, aus denen Seltenerdmetall/Gallium-Granat-Einkristalle gezüchtet werden sollen. Es war bisher bekannt, Seltenerdmetall/Gallium-Granat-Einkristalle nach dem Tiegelschmelzverfahren nach Czochralski zu züchten. Hierbei treten jedoch häufig Schwierigkeiten auf, die mit dem Tiegel nach der Erfindung umgangen werden können. Die Schwierigkeiten beim Tiegelschmelzverfahren, wie aber auch bei Anwendung der bekannten kalten Tiegel können z. B. darin bestehen, daß, insbesondere bei großen Schmelzenvolumina, häufig turbulente Schmelzenkonvektionen, gekoppelt mit Temperaturoszillationen und Fluktuationen auftreten können, die zu instabilen Wachstumsperioden und zu ausgeprägten Wachstumsstreifen in den gezüchteten Kristallen führen können.

Weitere Vorteile des erfindungsgemäßen Tiegels sind, daß im Vergleich zu Tiegeln für das Tiegelschmelzverfahren nach Czochralski die Menge des benötigten Edelmetalls, z. B. Iridium, zur Herstellung der Tiegelvorrichtung erheblich geringer ist. Wird z. B. ein Iridiumtiegel von 3,5 kg Gewicht für 6 kg Schmelze benötigt, so beträgt die Iridiummenge für einen kalten Tiegel gleichen Inhalts nach der Erfindung (für den Körper und den Behälter) nur 0,6 kg. Ein weiterer Vorteil ist, daß die Verunreinigungsgefahr der Schmelze durch das Tiegelmaterial gegenüber Tiegeln für das Tiegelschmelzverfahren erheblich geringer ist bei dem kalten Tiegel nach der Erfindung, weil ein großer Teil der Tiegelinnenwandung durch eine arteigene gesinterte, in fester Phase vorliegende Schicht gebildet wird.

Bei Tiegeln für das Tiegelschmelzverfahren führen Defekte im Tiegel wie Risse, Löcher etc. zum Verlust von Schmelze. Die in fester Phase vorliegende Sinterschicht auf der gekühlten Innenwandung des kalten Tiegels gemäß der Erfindung ist dagegen ein sicherer Schutz gegen das Auslaufen von Schmelze.

Anhand der Zeichnung werden Ausführungsbeispiele der Erfindung beschrieben und in ihrer Wirkungsweise erläutert. Es zeigen:

Fig. 1 einen Tiegel nach der Erfindung im Schnitt.

Fig. 2 den Behälter für den Tiegel nach der Erfindung im Schnitt in vergrößerter Darstellung unter Darstellung der Strömungsverhältnisse in der im Behälter befindlichen Schmelze.

Fig. 3 den Behälter für den Tiegel nach der Erfindung im Schnitt in abgewandelter, vergrößerter Darstellung unter Darstellung der Strömungsverhältnisse innerhalb der im Behälter enthaltenen Schmelze.

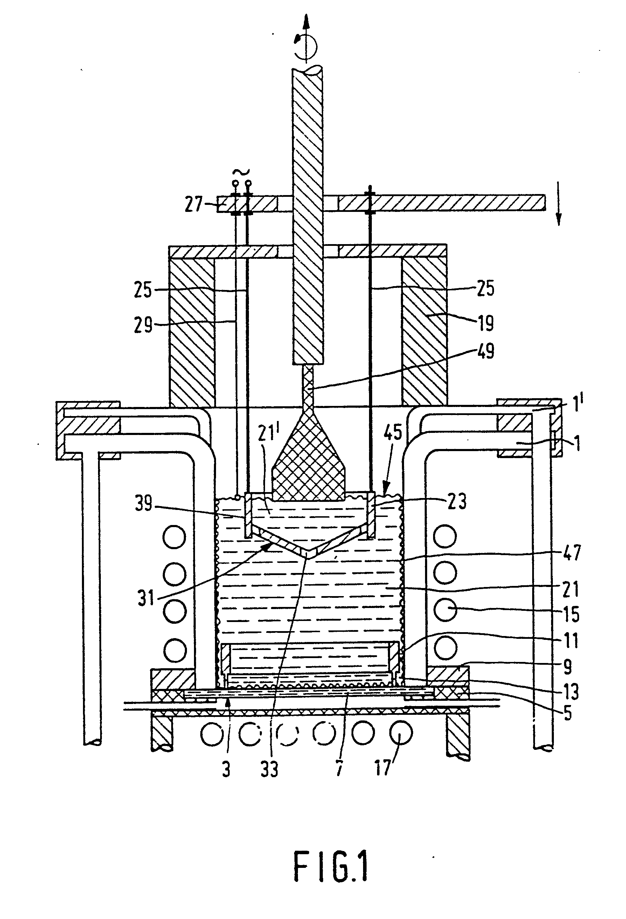

Fig. 1 zeigt einen kalten Tiegel nach der Erfindung im Schnitt. Der Tiegel besteht aus von Kühlmedium, vorzugsweise Wasser, durchströmten, rechtwinklig gebogenen, doppelwandig ausgeführten Metallrohren 1,1', vorzugsweise aus Kupfer, die kreisförmig angeordnet sind. Die äußeren Rohre 1 haben untereinander einen Abstand von 0,3 mm und sind unten verschlossen. Die Oberfläche der Rohre 1,1' sollte zweckmäßigerweise gegen Oxidationseinflüsse geschützt sein, dies kann bei Kupferrohren durch eine etwa 6 µm dicke Beschichtung mit Rhodium erfolgen. Den von Kühlmedium durchspülten Tiegelboden 3 bilden ein Grundkörper 5, der z. B. aus einem hitzebeständigen Kunststoff bestehen kann, eine Platte 7 aus gegenüber der Schmelze inertem, dielektrischem Material, z. B. Quarz, und ein Ring 9 aus ebenfalls dielektrischem Material, z. B. $Al_2O_3$, der der aus den Rohren 1 bestehenden Tiegelwandung zusätzliche Stabilität verleiht und sie in ihrer Lage fixiert. Der Grundkörper 5 hat Ausnehmungen zur Aufnahme der Platte 7 und ist mit dem Ring 9 vorzugsweise über eine Verschraubung verbunden. Ein Körper 11 aus elektrisch leitfähigem, gegenüber der Schmelze inertem Material (hier ein Ring aus Iridium) steht mit Füßen 13 auf der Platte 7. Die aus den Rohren 1 gebildete Tiegelwandung umschließt ein Rohr aus hitzebeständigem Material, z. B. aus Quarz (nicht dargestellt) und eine ringförmige Induktionsspule 15, über die Hochfrequenz-Energie in den Tiegelinhalt einkoppelbar ist. Die Induktionsspule 15 ist mit einem nicht dargestellten Hochfrequenz-Generator verbunden, dessen Arbeitsfrequenz zwischen 1 und 7 MHz liegt. Unterhalb des Tiegelbodens 3 ist eine zweite Induktionsspule 17 angeordnet, über die vorzugsweise Energie einer geringeren Frequenz als sie über die erste Induktionsspule 15 in den Tiegelinhalt eingespeist wird, in den Tiegelinhalt einkoppelbar ist. Die zweite Induktionsspule 17 ist an einen nicht dargestellten Generator angeschlossen, der z. B. eine Arbeitsfrequenz im Bereich von 7 bis 10 kHz hat. Beide Generatoren können unabhängig voneinander geschaltet werden. Auf dem oberen Tiegelrand ist ein Aufbau 19 aus hitzebeständigem Material, z. B. Oxidkeramik, angeordnet, der der Verringerung von Wärmeverlusten dient. In eine im Tiegel befindliche Schmelze 21 taucht ein Behälter 23 aus einem gegenüber der Schmelze inerten Material, z. B. Iridium, ein. Der Behälter 23 hat einen flach geneigten, in Richtung auf den Tiegelboden hin kegelförmigen Boden 31 und ist über Stäbe 25 mit einer Antriebsvorrichtung 27 verbunden, die vertikal bewegbar ist und zum Absenken oder Anheben des Behälters 23 dient. Ein Detektor 29 ist gemeinsam mit einem der Stäbe 25 an eine elektrische Schaltung angeschlossen und dient als Meßinstrument für die Füllstandshöhe der Schmelze 21. Der Detektor 29 besteht ebenfalls aus einem gegenüber der Schmelze inerten Material, z. B. Iridium.

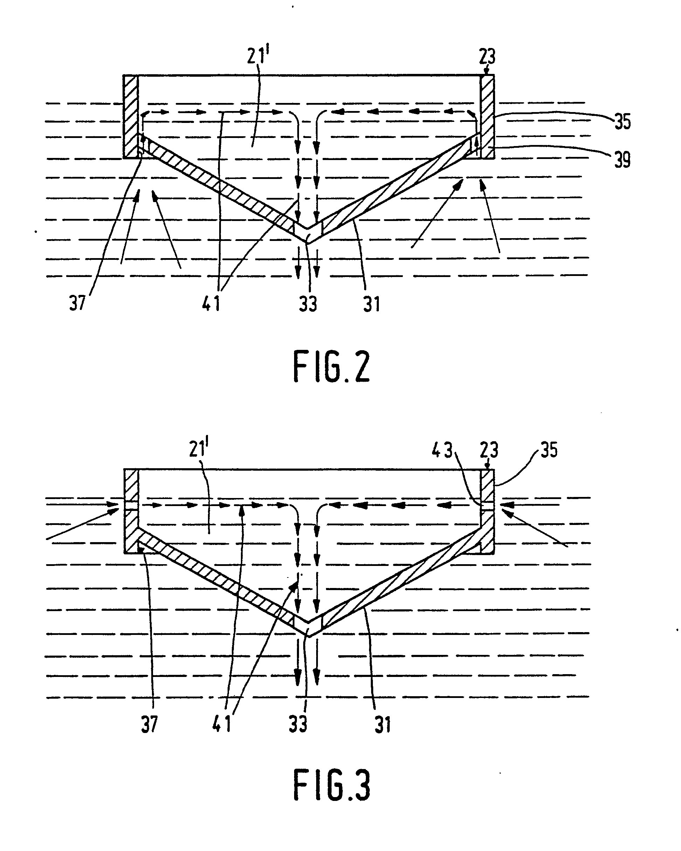

In Figur 2 ist in vergrößerter Darstellung der Behälter 23 im Schnitt gezeigt. Der kegelförmige Behälterboden 31 besitzt in der Mitte eine Öffnung 33, in diesem Beispiel eine kreisrunde Öffnung mit einem Durchmesser von 8 mm. Der Behälter hat einen Innendurchmesser von 76 mm eine Höhe der zylindrischen Wandung von 20 mm bei einer Wandstärke von 2 mm. Der kegelförmige Boden 31 ist an einem, an der Innenwand des Behälters befestigten Ring 35 befestigt, derart, daß ein 2 bis 3 mm breiter überstehender Rand 37 entsteht. Das Material für alle Teile des Behälters 23 ist gegenüber der Schmelze inert und ist in diesem Beispiel Iridium. Zwischen dem Ring 35 und dem Boden 31 sind sich diametral gegenüberliegende Schlitze 39 mit einer Länge von 20 bis 30 mm und einer Breite < 1 mm vorgesehen. Mit den Pfeilen 41 ist schematisch die Richtung der Konvektionsströme in der Schmelze 21' dargestellt. Der Behälter 23 wird innerhalb des Tiegels gemäß Fig. 1 so positioniert, daß er die Schmelze etwas überragt, vorzugsweise um 2 bis 5 mm.

In Figur 3 ist der Behälter 23 in gegenüber der Darstellung in Figur 2 etwas veränderter Ausführungsform dargestellt: Schlitze, die die Konvektion in der im Behälter befindlichen Schmelze 21' ermöglichen, sind hier auf dem Umfang der zylindrischen Seitenwand des Behälters 23 in Form von Schlitzen 43 vorgesehen. Die Abmessungen der Schlitze 43 entsprechen denen der Schlitze 39. Die übrigen Bezugszeichen entsprechen denen der Figur 2. Die Pfeile 41 beschreiben auch hier die Richtung der Konvektionsströme innerhalb der Schmelze 21'. Es ist vorteilhaft, Tiegel dieser Bauart innerhalb der Schmelze im Tiegel so zu positionieren, daß die Schlitze 43 dicht unter der Schmelzenoberfläche 45 (Fig. 1) liegen.

Die Betriebsweise des kalten Tiegels gemäß der Erfindung wird nun anhand eines Ausführungsbeispiels für die Herstellung von Einkristallen auf der Basis von Seltenerdmetall/Gallium-Granat beschrieben:

Für den Schmelzprozeß wird der Tiegel gemäß Figur 1 mit pulverförmigem Ausgangsmaterial in Form von z. B. $Nd_3Ga_5O_{12}$ gefüllt. Die Generatoren zur Erregung der Induktionsspulen 15 und 17 werden beide gleichzeitig eingeschaltet.

Hierbei koppelt zunächst vorzugsweise Energie über die Induktionsspule 17 in den Körper 11 ein und erwärmt ihn auf eine Temperatur oberhalb des Schmelzpunktes des Granatmaterials (1550° C). Nachdem sich im unteren Tiegelbereich ein ausreichendes Schmelzenvolumen gebildet hat, koppelt auch Energie über die die Tiegelwandung umgebende Induktionsspule 15 direkt in die Schmelze 21 ein. Der Aufheizprozeß wird solange fortgesetzt, bis der gesamte Tiegelinhalt als Schmelze vorliegt. Der Körper 11 am Boden des Tiegels hat zunächst die Aufgabe, den Prozeß des Aufschmelzens des pulverförmigen, zu erschmelzenden Materials in Gang zu setzen und ein gewisses Schmelzenvolumen zu bilden, so daß weitere hochfrequente Energie über die Induktionsspule 15 direkt in die Schmelze 21 einkoppeln kann. Der Körper 11 dient in dieser Phase des Schmelzprozesses also gewissermaßen als Vorheizer. Nach dem Aufsschmelzen des gesamten im Tiegel enthaltenen Materials übernimmt der Körper 11 die Funktion einer unabhängig regelbaren Zusatzheizung. An der gekühlten Tiegelinnenwandung und am gekühlten Tiegelinnenboden bildet sich eine Sinterschicht 47.

Das Dickenwachstum dieser Sinterschicht 47 kann durch Veränderung der Heizleistung beider Induktionsspulen 15 und 17 innerhalb bestimmter Grenzen gesteuert werden. Die Zusatzheizung in Form des Körpers 11 trägt daher wesentlich zur Stabilisierung des Schmelzprozesses bei. Bei keinem der mit dem erfindungsgemäßen Tiegel durchgeführten Versuche wurde das kritische Schmelzenvolumen erreicht. Die Form des als Zusatzheizung wirkenden Körpers 11 kann den Erfordernissen der Praxis angepasst sein. In dem oben beschriebenen Beispiel wurde ein Körper 11 in Ringform eingesetzt. Es kann aber zum Beispiel der Körper 11 auch als Scheibe ausgebildet sein, die einen geringfügig kleineren Durchmesser hat als der Innendurchmesser des Tiegelbodens, wobei die Scheibe massiv sein kann oder mit Öffnungen, z. B. Löchern oder Schlitzen, versehen sein kann; sie kann vorteilhafterweise jedoch auch eine mit oder ohne Öffnungen versehene Scheibe sein, die eine auf der Scheibe stehende Seitenwandung hat.

Der Behälter 23 befindet sich während der Aufheizperiode oberhalb des Tiegelinhaltes. Nachdem sich eine freie Schmelzenoberfläche 45 gebildet hat, wird der Behälter 23 mit Hilfe der mechanischen Antriebsvorrichtung 27 in die Schmelze 21 abgesenkt. Er wird in der Weise positioniert, daß der obere Rand des Behälters 23 2 bis 5 mm aus der Schmelze 21 herausragt. Durch die Öffnung 33 im Boden 31 des Behälters 23 und die Schlitze 39 bzw. 43 füllt sich der Behälter 23 mit Schmelze 21'. Der Behälter 23 dient zur Einstellung einer radialen Temperaturverteilung mit einem Temperaturminimum im Zentrum der Schmelzenoberfläche 45. Die Schmelze 21 dringt durch die Schlitze 39, 43 in den Behälter 23 ein, strömt als Schmelze 21' unter Abkühlung zur Mitte des Behälters 23 und verläßt denselben durch die Öffnung 33 im Behälterboden 31. Das hier beschriebene Strömungsbild wurde in einem Simulationsversuch unter Verwendung von Aluminium-Partikeln und Wasser beobachtet. Die Pfeile 41 in den Figuren 2 und 3 geben schematisch die Strömungsrichtung der Partikel wieder. Bei Granatschmelzen sind die Flußlinien innerhalb des Behälters 23 schwach ausgebildet und laufen speichenartig im Zentrum zusammen. Ein solches Flußlinienbild entsteht erfahrungsgemäß bei radialer Temperaturverteilung in der Schmelze.

Zur Züchtung eines Einkristalls wird nach einer Stabilisierungszeit von ca. 15 Minuten ein Impfkristall 49 mit der Schmelzenoberfläche 45 in Kontakt gebracht. Der Kristall wird anschließend unter Rotation von der Schmelze nach oben gezogen. Durch langsame Erniedrigung der Leistung des mit der Induktionsspule 15 verbundenen Generators wird der Durchmesser des wachsenden Kristalls bis auf den gewünschten Enddurchmesser vergrößert. Anschließend wird die Leistung dieses Generators in der Weise geregelt, daß der Kristall mit konstantem Durchmesser weiterwächst. Während des Kristallwachstums wird der Behälter 23 mittels der Antriebsvorrichtung 27 entsprechend dem absinkenden Schmelzenniveau nachgeführt, so daß die Schmelzenhöhe im Behälter 23 konstant bleibt. Die Änderung des Schmelzenniveaus ermittelt der Detektor 29, dessen Signal die Antriebsvorrichtung 27 steuert.

Nach Beendigung des Kristallwachstums wird zunächst der gewachsene Kristall durch schnelles Hochziehen von der Restschmelze getrennt. Anschließend wird der Behälter 23 aus der Schmelze 21 herausgezogen und der Kristall durch Erniedrigung der Leistung der mit den Induktionsspulen 15 und 17 verbundenen Generatoren auf Raumtemperatur abgekühlt. Für die Züchtung von $Nd_3Ga_5O_{12}$-Einkristallen nach dem oben beschriebenen Verfahren wurde als Ausgangsmaterial 6 kg $Nd_3Ga_5O_{12}$ in den Tiegel gefüllt. Als Impfkristall wurde ein $Nd_3Ga_5O_{12}$-Einkristall verwendet. Während des Wachstums wurde der anwachsende Kristall mit einer Geschwindigkeit von 14 min$^{-1}$ gedreht und mit einer Geschwindigkeit von 4 mm/h von der Schmelze abgezogen. Es wurden $Nd_3Ga_5O_{12}$-Einkristalle einer Länge bis zu 60 mm und eines Durchmessers bis zu 40 mm gezüchtet. Messungen an den derart gezüchteten Kristallen zeigten, daß aus dem kalten Tiegel gemäß der Erfindung gezüchtete Kristalle Wachstumsstreifen mit schwächerer Spannungsdoppelbrechung aufwiesen als Kristalle, die nach dem Tiegelschmelzverfahren nach Czochralski hergestellt worden waren.

Das oben beschriebene Verfahren kann in der Weise abgeändert werden, daß das Schmelzenniveau durch Zufuhr von nichtgeschmolzenem Material in den Tiegel in den Raum zwischen dem Behälter 23 und der aus den Rohren 1 gebildeten Tiegelwandung aus einer mittels des Detektors 29 gesteuerten Nachfüllvorrichtung konstant gehalten wird. Bei dieser Betriebsart bleibt die Position des Behälters 23 unverändert.

Als weiteres Ausführungsbeispiel wurden NaCl-Einkristalle hergestellt. Der in Figur 1 dargestellte Tiegel wurde mit 2 kg NaCl gefüllt und es wurde nach dem oben für die Züchtung von $Nd_3Ga_5O_{12}$-Einkristallen beschriebenen Verfahren vorgegangen. Als Impfkristall diente ein NaCl-Einkristall. Während des Wachstums wurde der anwachsende Kristall mit einer Geschwindigkeit von 20 min$^{-1}$ gedreht und mit einer Geschwindigkeit von 18 mm/h von der Schmelze abgezogen. Es wurden NaCI-Einkristalle einer Länge bis zu 190 mm und eines Durchmessers bis zu 55 mm gezüchtet.

## Bezugszeichenliste

1,1' Metallrohr
3 Tiegelboden
5 Grundkörper
7 Platte
9 Ring
11 Körper
13 Fuß
15 Induktionsspule
17 Induktionsspule
19 Aufbau
21, 21' Schmelze
23 Behälter
25 Stab
27 Antriebsvorrichtung
29 Detektor
31 Behälterboden
33 Öffnung in 31
35 Ring
37 Rand
39 Schlitz in 31
41 Strömungsrichtungspfeil
43 Schlitz in 23
45 Schmelzenoberfläche
47 Sinterschicht
49 Impfkristall

## Patentansprüche

1. Kalter Tiegel für das Erschmelzen und die Kristallisation nichtmetallischer anorganischer Verbindungen mit einer gekühlten Tiegelwandung in Form von von Kühlmedium durchströmten Metallrohren, die in mechanischer Verbindung stehen mit dem ebenfalls von Kühlmedium durchspülten Tiegelboden und mit einer ersten Induktionsspule, die die Tiegelwandung umgibt und über die Hochfrequenz-Energie in den Tiegelinhalt einkoppelbar ist, sowie mit einer zweiten, unabhängig von der die Tiegelwandung umgebenden Induktionsspule zu schaltenden Induktionsspule, die unterhalb des Tiegelbodens angeordnet ist, dadurch gekennzeichnet, daß innerhalb des Tiegels mit einem Abstand über dem Tiegelboden (3) ein Körper (11) aus einem inerten, elektrisch leitfähigen Material und ein zur offenen Seite des Tiegels hin offener, mit Öffnungen (33, 39, 43) versehener, aus einem inerten Material bestehender Behälter (23), der einen solchen Abstand von der Tiegelwandung und vom Tiegelboden hat, daß in ihm bis zu 25 % des gesamten Tiegelinhaltes enthalten sind, vorgesehen sind.

2. Kalter Tiegel nach Anspruch 1, dadurch gekennzeichnet, daß der Körper (11) ein Ring ist.

3. Kalter Tiegel nach Anspruch 1, dadurch gekennzeichnet, daß der Körper (11) eine massive Scheibe ist.

4. Kalter Tiegel nach Anspruch 1, dadurch gekennzeichnet, daß der Körper (11) eine mit Öffnungen versehene Scheibe ist.

5. Kalter Tiegel nach Anspruch 1, dadurch gekennzeichnet, daß der Körper (11) eine mit oder ohne Öffnungen versehene Scheibe mit einer aufgesetzten Seitenwandung ist.

6. Kalter Tiegel nach Anspruch 1, dadurch gekennzeichnet, daß der Tiegelboden (3) aus dielektrischem Material besteht.

7. Kalter Tiegel nach Anspruch 6, dadurch gekennzeichnet, daß der Tiegelboden (3) aus einer Platte (7), vorzugsweise aus Quarz, besteht unter der das Kühlmedium fließt und die in eine Halterung (5) aufgenommen ist, die mit federnd gelagerten Stützen in Verbindung steht.

8. Kalter Tiegel nach Anspruch 1, dadurch gekennzeichnet, daß als Kühlmedium Wasser vorgesehen ist.

9. Kalter Tiegel nach Anspruch 1, dadurch gekennzeichnet, daß der Körper (11) und der Behälter (23) aus Iridium bestehen.

10. Kalter Tiegel nach Anspruch 1, dadurch gekennzeichnet, daß der Körper (11) und der Behälter (23) aus Platin bestehen.

11. Kalter Tiegel nach Anspruch 1, dadurch gekennzeichnet, daß der Körper (11) und der Behälter (23) aus Graphit bestehen.

12. Kalter Tiegel nach Anspruch 1, dadurch gekennzeichnet, daß die die Tiegelwandung bildenden Metallrohre (1) aus Kupfer bestehen.

13. Kalter Tiegel nach Anspruch 12, dadurch gekennzeichnet, daß die Metallrohre eine eine Oxidation verhindernde Beschichtung haben.

14. Kalter Tiegel nach Anspruch 1, dadurch gekennzeichnet, daß eine Antriebsvorrichtung (27) vorgesehen ist, mittels welcher der Behälter (23) vertikal bewegbar ist.

15. Kalter Tiegel nach Anspruch 1, dadurch gekennzeichnet, daß ein Detektor (29) zur Messung der Füllstandshöhe der Schmelze (21) vorgesehen ist.

16. Kalter Tiegel nach Anspruch 1, dadurch gekennzeichnet, daß der Behälter (23) eine dem zu züchtenden Kristall angepasste Geometrie hat.

17. Kalter Tiegel nach Anspruch 16, dadurch gekennzeichnet, daß der Behälter (23) eine Geometrie hat, derart, daß die Behälterwandung sich parallel zur Tiegelwandung und daß der Behälterboden (31) sich kegelförmig in Richtung auf den Tiegelboden (3) hin erstreckt.

18. Kalter Tiegel nach Anspruch 1, dadurch gekennzeichnet, daß die Öffnungen (33, 39, 43) im Behälter (23) in der Behälterwandung und/oder im Behälterboden (31) angebracht sind.

19. Verwendung des Tiegels nach den Ansprüchen 1 bis 18 zum Züchten von Einkristallen aus Schmelzen auf der Basis von Seltenerdmetall/Gallium-Granat.

## Claims

1. A cold crucible for melting and crystallizing non-metallic inorganic compounds having a cooled crucible wall in the form of metal pipes through which cooling medium flows and which are in mechanical connection with the bottom of the crucible through which cooling medium also flows and having a first induction coil which surrounds the wall of the crucible and via which high-frequency energy can be coupled into the contents of the crucible, as well as a second induction coil which can be switched independently of the induction coil currounsing the wall of the crucible and which is arranged below the bottom of the crucible, characterized in that there are present inside the crucible, at a distance above the bottom (3) of the crucible, a member (11) of an inert electrically conductive material and a container (23) which is open towards the open side of the crucible, comprises apertures (33, 39, 43), consists of an inert material which container has a distance from the wall of the crucible and from the bottom of the crucible such that up to 25 % of the overall crucible contents are contained in it.

2. A cold crucible as claimed in Claim 1, characterized in that the member (11) is a ring.

3. A cold crucible as claimed in Claim 1, characterized in that the member (11) is a solid disc.

4. A cold crucible as claimed in Claim 1, characterized in that the member (11) is an apertured disc.

5. A cold crucible as claimed in Claim 1, characterized in that the member (11) is a disc with or without apertures having an upright sidewall.

6. A cold crucible as claimed in Claim 1, characterized in that the bottom (3) of the crucible consists of a dielectric material.

7. A cold crucible as claimed in Claim 6, characterized in that the bottom (3) of the crucible consists of a plate (7), preferably of quartz, below which the cooling medium flows and which is incorporated in a holder (5) which is connected to spring journalled supports.

8. A cold crucible as claimed in Claim 1, characterized in that water is present as a cooling medium.

9. A cold crucible as claimed in Claim 1, characterized in that the member (11) and the container (23) consist of iridium.

10. A cold crucible as claimed in Claim 1, characterized in that the member (11) and the container (23) consist of platinum.

11. A cold crucible as claimed in Claim 1, characterized in that the member (11) and the container (23) consist of graphite.

12. A cold crucible as claimed in Claim 1, characterized in that the metal pipes (1) forming the wall of the crucible consist of copper.

13. A cold crucible as claimed in Claim 12, characterized in that the metal pipes have a coating which prevents oxidation.

14. A cold crucible as claimed in Claim 1, characterized in that a driving device (27) is present by means of which the container (23) can be moved vertically.

15. A cold crucible as claimed in Claim 1, characterized in that a detector (29) is present for measuring the level of filling of the melt (21).

16. A cold crucible as claimed in Claim 1, characterized in that the container (23) has a geometry which is adapted to the crystal to be grown.

17. A cold crucible as claimed in Claim 16, characterized in that the container (23) has a geometry such that the wall of the container extends parallel to the wall of the crucible and that the bottom (31) of the container extends conically in the direction towards the bottom (3) of the crucible.

18. A cold crucible as claimed in Claim 1, characterized in that the apertures (33, 39, 43) in the container (23) are provided in the wall of the container and/or in the bottom (31) of the container.

19. The use of the crucible as claimed in Claims 1 to 18 for growing single crystals from melts on the basis of rare earth metal/gallium garnet.

## Revendications

1. Creuset froid pour la fusion et la cristallisation de composés inorganiques non métalliques muni d'une paroi de creuset refroidie sous forme de tubes métalliques traversés par du fluide de refroidissement qui sont en liaison mécanique avec le fond de creuset également traversé par du fluide de refroidissement et d'une première bobine d'induction, qui entoure la paroi de creuset et par l'intermédiaire de laquelle de l'énergie à haute fréquence peut être couplée au contenu de creuset et d'une deuxième bobine d'induction à commuter indépendamment de la bobine d'induction entourant la paroi du creuset et disposée au-dessous du fond du creuset, caractérisé en ce que dans le creuset sont disposés, à quelque distance au-dessus du fond du creuset (3), un corps (11) en un matériau électroconducteur inerte et un récipient (23) constitué par un matériau inerte muni d'ouvertures (33, 39, 43) et ouvert vers le c*oté ouvert du creuset, le récipient étant éloigné de la paroi du creuset et du fond de ce dernier d'une distance telle que son contenu peut être 25 % du contenu total du creuset.

2. Creuset froid selon la revendication 1, caractérisé en ce que le corps (11) est un anneau.

3. Creuset froid selon la revendication 1, caractérisé en ce que le corps (11) est un disque massif.

4. Creuset froid selon la revendication 1, caractérisé en ce que le corps (11) est un disque muni d'ouvertures.

5. Creuset froid selon la revendication 1, caractérisé en ce que le corps (11) est un disque muni ou non d'ouvertures présentant une paroi latérale relevée.

6. Creuset froid selon la revendication 1, caractérisé en ce que le fond de creuset (3) est en matériau diélectrique.

7. Creuset froid selon la revendication 6, caractérisé en ce que le fond de creuset (3) est constitué par une plaque (7) de préférence en quartz, au-dessous de laquelle circule le fluide de refroidissement et qui est disposée dans un support (5) relié à des appuis montés élastiquement.

8. Creuset froid selon la revendication 1, caractérisé en ce que comme fluide de refroidissement, on utilise de l'eau.

9. Creuset froid selon la revendication 1, caractérisé en ce que le corps (11) et le récipient (23) sont en iridium.

10. Creuset froid selon la revendication 1, caractérisé en ce que le corps (11) et le récipient (23) sont en platine.

11. Creuset froid selon la revendication 1, caractérisé en ce que le corps (11) et le récipient (23) sont en graphite.

12. Creuset froid selon la revendication 1, caractérisé en ce que les tubes métalliques (1) constituant la paroi du creuset sont en cuivre.

13. Creuset froid selon la revendication 12, caractérisé en ce que les tubes métalliques présentent une couche empêchant l'oxydation.

14. Creuset froid selon la revendication 1, caractérisé en ce qu'il est prévu un dispositif d'entraînement (27) à l'aide duquel le récipient (23) peut être déplacé verticalement.

15. Creuset froid selon la revendication 1, caractérisé en ce qu'il est prévu un détecteur (29) pour la mesure de la hauteur du niveau de bain (21).

16. Creuset froid selon la revendication 1, caractérisé en ce que le récipient (23) présente une géométrie qui est adaptée au cristal à former.

17. Creuset froid selon la revendication 16, caractérisé en ce que le récipient (23) présente une géométrie telle que la paroi du récipient s'étend parallèlement à la paroi du creuset et que le fond du récipient (31) s'étend de façon conique dans la direction du fond de creuset (3).

18. Creuset froid selon la revendication 1, caractérisé en ce que les ouvertures (33, 39, 43) du récipient (23) sont ménagées dans la paroi du récipient et/ou dans le fond de récipient (31).

19. Application du creuset selon les revendications 1 à 18, pour la formation de monocristaux à partir des bains à base de grenat de métal des terres rares/gallium.

FIG.1

FIG.2

FIG.3